# EUROPÄISCHE PATENTSCHRIFT

(11) **EP 1 384 266 B1**
(45) Veröffentlichungstag und Bekanntmachung des Hinweises auf die Patenterteilung: **26.03.2008**
(21) Anmeldenummer: 02745234.1
(22) Anmeldetag: 17.04.2002
(51) Int. Cl.: H01L 25/16, H01L 31/173

(54) **ANORDNUNG MIT MINDESTENS ZWEI UNTERSCHIEDLICHEN ELEKTRONISCHEN HALBLEITERSCHALTUNGEN**
ARRANGEMENT COMPRISING AT LEAST TWO DIFFERENT ELECTRONIC SEMICONDUCTOR CIRCUITS
CIRCUITERIE A AU MOINS DEUX CIRCUITS SEMI-CONDUCTEURS ELECTRONIQUES DIFFERENTS

(30) Priorität: 30.04.2001 DE 10121422; 08.09.2001 DE 10144207
(43) Veröffentlichungstag der Anmeldung: 28.01.2004
(73) Patentinhaber: MergeOptics GmbH, 13507 Berlin (DE)
(72) Erfinder: NEUMEUER, Dag, 81247 München (DE); BRAHMS, Martin, 31552 Rodenberg (DE)
(74) Vertreter: Bittner, Thomas L.
(86) Internationale Anmeldenummer: PCT/EP2002/004226
(87) Internationale Veröffentlichungsnummer: WO 2002/089208

(56) Entgegenhaltungen:
- EP-A- 0 762 157
- EP-A- 0 987 769
- DE-A- 3 409 146
- DE-A- 4 310 170
- US-A- 4 778 244
- US-A- 5 522 004
- US-A- 6 132 107

## Beschreibung

Die Erfindung bezieht sich auf eine Anordnung mit mindestens zwei unterschiedlichen elektronischen Halbleiterschaltungen, bei welcher jede der Halbleiterschaltungen ein Bauteil aus Halbleitermaterial ist, das eine elektrisch aktive Fläche und elektrische Kontakte aufweist, und bei welcher korrespondierende Kontakte der Halbleiterschaltungen elektrisch leitend miteinander verbunden sind (DE 34 09 146 A1).

Eine solche Anordnung wird beispielsweise bei der Datenübertragung über Glasfasern bzw. Lichtwellenleiter benötigt. Die Anordnung aus Halbleiterschaltungen kann dabei als Empfänger oder als Sender ausgeführt sein. Bei einem Empfänger werden beispielsweise eine Fotodiode und ein als Vorverstärker wirkender Transimpedanzverstärker eingesetzt. Bei einem Sender können als Halbleiterschaltungen eine Laserdiode und eine Treiberschaltung verwendet werden. Da die Problematik beim Aufbau entsprechender Anordnungen in allen Fällen etwa die gleiche ist, wird im folgenden - stellvertretend für alle anderen Anwendungsfälle - ein aus Halbleiterschaltungen bestehender Empfänger für optische Signale berücksichtigt.

In heute üblicher Technik werden elektronische Halbleiterschaltungen auf sogenannten Wafern erzeugt. Das sind relativ dünne, von einem Block abgetrennte Scheiben aus einem geeigneten Halbleitermaterial. Geeignete Halbleitermaterialien sind beispielsweise Silizium, Gallium-Arsenid und Indium-Phosphid. Auf solchen Wafern wird eine sehr große Anzahl von in der Regel identischen Halbleiterschaltungen in speziellen Prozessen erzeugt. Neben den dabei aufgebrachten aktiven Flächen (Halbleiterschaltungsflächen) werden auch elektrische Kontakte erzeugt, die mit den aktiven Flächen verbunden sind und beispielsweise zum elektrisch leitenden Verbinden zu korrespondierenden Halbleiterschaltungen, zu einem Leadframe, zu einem Trägersubstrat oder zu einer tragenden Leiterplatte dienen. Dazu werden in bekannter Technik Drähte aus elektrisch gut leitendem Material verwendet, beispielsweise aus Gold oder Aluminium, die durch Bonden elektrisch leitend mit den Kontakten von beispielsweise zwei Halbleiterschaltungen verbunden werden (DE 43 10 170 A1). Solche Drähte können sich bei einer schnellen Datenübertragung mit im GHz-Bereich liegenden Frequenzen störend auswirken und dabei zu einer Signalverformung bis hin zu unbrauchbaren, d. h. nicht auswertbaren Signalen führen.

Aus der eingangs erwähnten DE 34 09 146 A1 geht eine als optoelektronisches Modul bezeichnete Anordnung hervor, bei der auf einem beispielsweise aus Silizium bestehenden Substrat aus Halbleitermaterial mindestens ein Verstärkerelement in integrierter Technik angebracht ist. Das Substrat weist eine Grube auf, in welche ein Lichtmodulator, beispielsweise ein Festkörperlaser, eingesetzt ist. Er ist in der Grube mit dem Substrat beispielsweise verklebt. Der Lichtmodulator ist mit einem Verstärkerelement des Substrats durch einen Bonddraht elektrisch leitend verbunden. Die Herstellung dieser bekannten Anordnung ist aufwendig. Sie kann nur für vertikalen Lichteinfall verwendet werden. Der Bonddraht kann sich, wie oben erwähnt, insbesondere bei sehr hohen Datenraten störend auswirken.

Das Dokument EP-A-0 987 769 beschreibt ein Photodiodenmodul mit einem Träger, an dem in einer V-Rille eine optische Faser angeordnet ist, wobei das durch die optische Faser geführte Licht von einem auf dem Träger angeordneten Umlenkspiegel in eine Photodiode reflektiert wird.

Das Dokument DE 43 10 170 A beschreibt einen Halbleiterchip mit einem darauf angeordneten zusätzlichen Halbleiterchip.

Das Dokument US-A-6 132 107 beschreibt eine Vorrichtung mit einer optischen Faser, einem Umlenkspiegel und einer Photodiode, wobei der Umlenkspiegel das von der Faser kommende Licht in die Photodiode reflektiert.

Das Dokument US-A-4 778 244 beschreibt eine optische Faser aus einem thermotropischen Flüssigkristallpolymer.

Das Dokument US-A-5 522 004 offenbart eine Vorrichtung zur Kompensation der Dispersion in einer Faseroptik.

Der Erfindung liegt die Aufgabe zugrunde, die eingangs geschilderte Anordnung so zu gestalten, daß sie bei einfachem Aufbau auch bei höchsten Übertragungsgeschwindigkeiten eine störungsfreie Datenübertragung sicherstellt.

Diese Aufgabe wird gemäß der Erfindung gelöst entsprechend der Anordnung von Anspruch 1.

Weitere vorteilhafte Ausführungen sind in den abhängigen Ansprüchen 2-18 offenbart.

In dieser Anordnung können bei maximaler Ausnutzung des aus einheitlichem Material bestehenden Trägers beispielsweise alle für einen Sender und/oder Empfänger optischer Signale zur Datenübertragung über Glasfasern benötigten Elemente als Halbleiterschaltungen in einer einteiligen Einheit vorhanden und zusammengeschaltet sein. Neben Sende- und Empfangsdioden sowie Verstärkern können so auch weitere Halbleiterschaltungen im gemeinsamen Träger erzeugt werden, welche für eine gute Qualität der Datenübertragung benötigt werden bzw. sinnvoll sind. Solche weiteren Halbleiterschaltungen sind beispielsweise R-C-Glieder und Monitordioden oder auch Mikrocontroller zur Durchführung und Kontrolle von Übertragungsabläufen. Die Anordnung ist außerdem von der Richtung des einfallenden Lichts weitgehend unabhängig, da sowohl Fotodiode als auch Laserdiode unterschiedliche Positionen einnehmen können.

Die aus dem gleichen Material wie der Träger bestehende und eine Einheit mit demselben bildende Erweiterung desselben bietet die Möglichkeit, auf einfache Weise durch mikromechanische Strukturierung beispielsweise einen V-Graben zur Aufnahme eines Lichtwellenleiters in derselben anzubringen. Ein Lichtwellenleiter kann dann auf sehr einfache Weise positionsgenau zu einer Fotodiode oder einer Laserdiode auf bzw. in der Erweiterung angeordnet werden. Durch mikromechanische Strukturierung der Erweiterung können auch mehr als ein V-Graben in derselben angebracht sowie eine Unterlage zur Anbringung weiterer Schaltungselemente bzw. Komponenten geschaffen werden, die dann auf sehr einfache Weise mit den Halbleiterschaltungen des Trägers verbunden werden können. Solche Schaltungselemente bzw. Komponenten sind beispielsweise Relais, Linsen, Spiegelelemente, optische Filter, optische Isolatoren, optische Verstärker und als Verbinder dienende Lichtleiter.

Die Anordnung umfaßt auch die Möglichkeit, eine oder auch mehr als eine Halbleiterschaltung nachträglich auf dem Träger bzw. dessen Erweiterung anzuordnen, um eine komplette Schaltung zu erhalten. Das kann beispielsweise eine separat hergestellte Fotodiode oder Laserdiode sein, die so auf dem Träger angebracht werden kann, daß ihre elektrischen Kontakte direkt auf korrespondierenden Kontakten an der Oberfläche desselben liegen. In allen Ausführungsformen sind die Abstände zwischen den korrespondierenden Kontakten der einzelnen Halbleiterschaltungen sehr kurz. Diese elektrisch leitenden Verbindungen sind dementsprechend ebenfalls sehr kurz. Sie können dadurch keine wesentlichen parasitären Induktivitäten oder Kapazitäten erzeugen. Sie bewirken gegenüber bekannten Anordnungen auch deutlich geringere elektromagnetische Verkopplungen. Eine störende Wirkung der elektrisch leitenden Verbindungen zwischen den Halbleiterschaltungen auf die zu übertragenden Daten ist somit auch bei sehr hohen Frequenzen weitestgehend vermieden, insbesondere bei über 1 GHz liegenden Frequenzen.

Ausführungsbeispiele des Erfindungsgegenstands sind in den Zeichnungen dargestellt.

Es zeigen:
Fig. 1 schematisch eine Schaltung zum Empfang optischer Signale.
Fig. 2 und 3 ebenfalls schematisch zwei unterschiedliche Halbleiterschaltungen.
Fig. 4 eine Draufsicht auf einen Wafer mit eine Vielzahl von Halbleiterschaltungen.
Fig. 5 eine Anordnung nach der Erfindung.
Fig. 6 eine Seitenansicht eines in der Anordnung verwendbaren Trägers.
Fig. 7 eine Einzelheit der Anordnung in schematischer Darstellung.
Fig. 8 eine Stirnansicht der Anordnung nach Fig. 7 im Ausschnitt und in vergrößerter Darstellung.

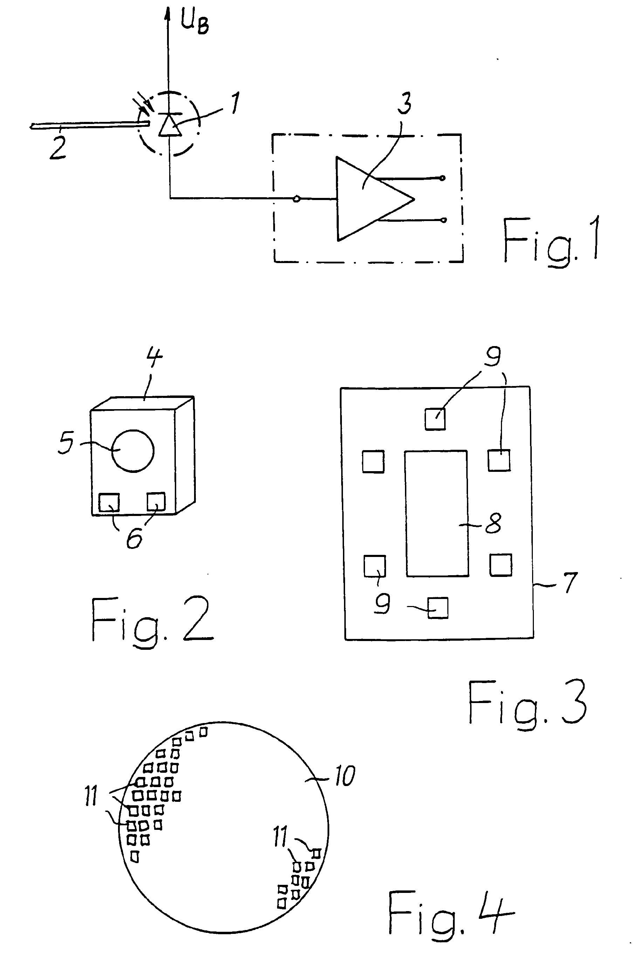

Zum besseren Verständnis der Anordnung nach der Erfindung werden anhand der Fig. 1 bis 4 zunächst grundlegende Erläuterungen für eine Empfangsschaltung optischer Signale bei der Datenübertragung über Glasfasern bzw. Lichtwellenleiter gegeben.

Die Empfangsschaltung nach Fig. 1 hat als eigentlichen Lichtempfänger eine Fotodiode 1, beispielsweise eine PIN-Diode, auf welche das Licht eines über einen Lichtwellenleiter 2 übertragenen Datenstroms fällt. An die als opto/elektrischer Wandler arbeitende Fotodiode 1 ist ein Verstärker 3 für elektrische Signale angeschlossen, durch welchen die von der Fotodiode 1 gelieferten Signale in weiterverarbeitbare Signale verstärkt werden. Als Verstärker 3 ist insbesondere ein Transimpedanzverstärker geeignet. Die für die Fotodiode 1 erforderliche Vorspannung ist mit U_{B} bezeichnet. Fotodiode 1 und Verstärker 3 sind Halbleiterschaltungen. Sie sind in diesem Sinne in Fig. 1 jeweils durch eine strichpunktierte Linie umrahmt.

Die Fotodiode 1 besteht gemäß Fig. 2 in herkömmlicher Technik aus einem Träger 4 aus Halbleitermaterial, beispielsweise aus Gallium-Arsenid oder Indium-Phosphid. Auf dem Träger 4 ist mit einem speziellen Prozess eine aktive Fläche 5 erzeugt worden. Die Fotodiode 1 hat im dargestellten Ausführungsbeispiel außerdem zwei an der gleichen Fläche des Trägers 4 liegende elektrische Kontakte 6. Die Kontakte 6 könnten auch an unterschiedlichen Flächen des Trägers 4 angebracht sein, beispielsweise an zwei einander gegenüberliegenden Flächen. Es können auch mehr als zwei Kontakte 6 vorhanden sein.

Ein in Fig. 3 schematisch dargestellter Träger 7 für den Verstärker 3 besteht beispielsweise aus dem gleichen Halbleitermaterial wie der Träger 4. Er hat eine aktive Fläche 8, die hier eine integrierte Schaltung beinhaltet. Auf dem Träger 7 ist außerdem eine größere Anzahl von Kontakten 9 angebracht. Sie können ebenso wie die Kontakte 6 der Fotodiode 1 beispielsweise aus Kupfer, Gold oder Aluminium bestehen.

Die Halbleiterschaltungen für Fotodiode 1 und Verstärker 3 werden in herkömmlicher Technik auf Wafern 10 hergestellt. Das sind Scheiben mit vorgegebener Dicke von beispielsweise 500 µm aus Halbleitermaterial, wie beispielsweise Silizium, Gallium-Arsenid und auch Indium-Phosphid. Auf einem Wafer 10 wird gleichzeitig eine sehr große Anzahl von Halbleiterschaltungen 11 hergestellt. Dabei werden zweckmäßig auf einem Wafer 10 identische Halbleiterschaltungen 11 erzeugt. Sie werden abschließend zur Weiterverarbeitung aus dem Wafer 10 vereinzelt. Die für eine komplette Schaltung erforderlichen Bauteile, hier beispielsweise Fotodiode 1 und Verstärker 3, werden dann durch elektrisch leitende Verbindung ihrer Kontakte zusammengeschaltet.

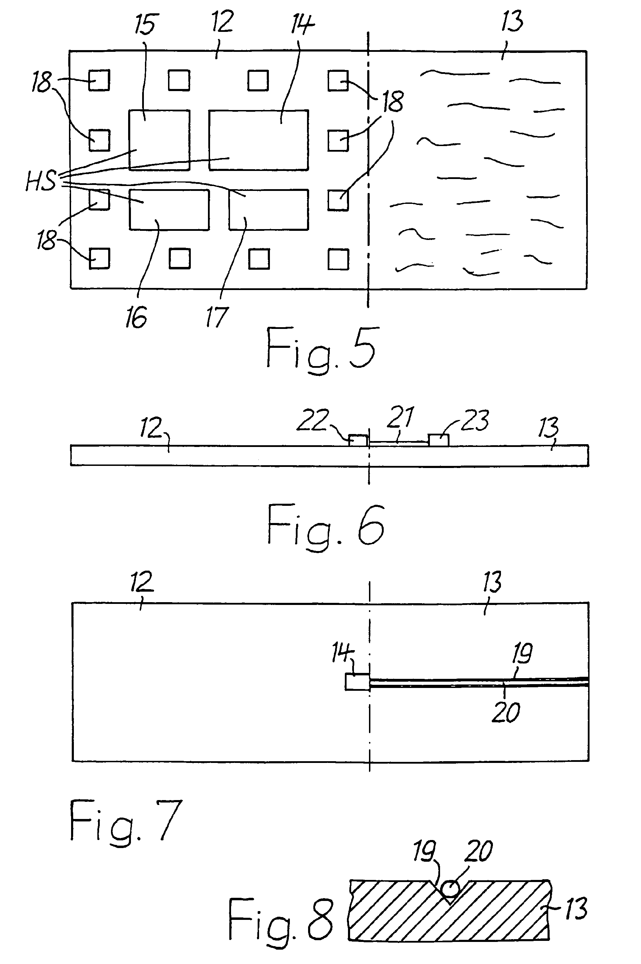

In der Anordnung nach der Erfindung sind mindestens zwei unterschiedliche Halbleiterschaltungen auf einem gemeinsamen Träger 12 aus Halbleitermaterial erzeugt, der eine durch eine strichpunktierte Linie abgegrenzte Erweiterung 13 aus dem gleichen Material hat. Bei der in Fig. 5 dargestellten Ausführungsform der Anordnung weist der Träger 12 aus Halbleitermaterial, wie Silizium, Gallium-Arsenid oder auch Indium-Phosphid, vier unterschiedliche Halbleiterschaltungen HS auf. Diese sind gemeinsam mit identisch aufgebauten oder auch anderen Anordnungen auf einem Wafer 10 erzeugt worden, so wie es für Fig. 4 erläutert ist.

Die Halbleiterschaltungen HS nach Fig. 5 sollen beispielsweise zu einer Empfangsschaltung für optische Signale gehören. Es sind beispielsweise eine Fotodiode 14, ein Verstärker 15, ein R-C-Glied 16 und ein Mikrocontroller 17. Auf der Oberfläche des Trägers 12 befinden sich außerdem mehrere elektrisch leitende Kontakte 18, die mit den Halbleiterschaltungen HS verbunden sind. Sie dienen gegebenenfalls zum elektrisch leitenden Anschluß weiterer, für eine optimale Datenübertragung benötigter oder sinnvoller Bauteile, die nicht im Träger 12 integriert sind.

Der Träger 12 wird in an sich üblicher Technik mit den Halbleiterschaltungen HS versehen. Beim Aufbau der unterschiedlichen Halbleiterschaltungen 14 bis 17 mit individuellen aktiven Flächen und Kontakten, können die elektrisch leitenden Verbindungen zwischen denselben gleichzeitig mit hergestellt werden. Abschließend wird der Träger 12 metallisiert, wodurch die mit den zugehörigen Halbleiterschaltungen HS verbundenen Kontakte 18 und gegebenenfalls auch die Verbindungen zwischen den Halbleiterschaltungen 14 bis 17 erzeugt werden. An die komplette Empfangsschaltung des Trägers 12 braucht nur noch mindestens ein Lichtwellenleiter (Glasfaser) angeschlossen zu werden, und zwar an die Fotodiode 14. Der Träger 12 kann dann zur Vervollständigung eines Übertragungssystems beispielsweise auf einem Verbindungsträger, beispielsweise einer Leiterplatte, angebracht werden. Die erforderlichen elektrisch leitenden Verbindungen werden über seine Kontakte 18 hergestellt.

Falls beispielsweise die Fotodiode 14 nicht gleichzeitig mit den anderen Halbleiterschaltungen HS im gemeinsamen Träger 12 erzeugt werden soll, kann sie als separat hergestelltes Bauteil mit einer Dicke von beispielsweise 100 µm bis 200 µm sehr einfach auf dem Träger 12 angebracht werden. Dazu braucht sie beispielsweise mit ihren Kontakten nur direkt auf die entsprechenden Kontakte 18 des Trägers 12 aufgelegt zu werden. Die elektrisch leitende Verbindung zwischen den Kontakten von Fotodiode 14 und Träger 12 ist dabei extrem kurz. Dieser Aufbau der Anordnung nach der Erfindung bietet sich beispielsweise dann an, wenn für die Halbleiterschaltungen von Fotodiode 14 einerseits und allen anderen Halbleiterschaltungen HS andererseits unterschiedliche Materialien eingesetzt werden sollen. So kann für die Fotodiode 14 beispielsweise Indium-Phosphid verwendet werden, während für die anderen Halbleiterschaltungen HS beispielsweise Silizium eingesetzt wird.

Wesentlich für die Anordnung nach der Erfindung ist der Aufbau einer einteiligen, aus Träger 12 und Erweiterung 13 bestehenden Halbleiter-Anordnung, in der möglichst viele - günstigsten Falls alle - für eine komplette Schaltung benötigten bzw. zu verwendenden Halbleiterschaltungen HS und Schaltelemente bzw. Komponenten vorhanden und elektrisch leitend miteinander verbunden sind. Für die schnelle Datenübertragung über Glasfasern verwendbare Halbleiterschaltungen HS sind einschließlich der für Fig. 5 bereits erwähnten Halbleiterschaltungen auch Laserdioden und Monitordioden. Als Halbleiterschaltung HS kann mit Vorteil auch ein intelligentes elektronisches Bauteil mit Speicherfunktion auf dem Träger 12 vorhanden sein, beispielsweise der oben bereits erwähnte Mikrocontroller 17. Ein solcher Mikrokontroller 17 kann beispielsweise Verfahrensabläufe bei der Datenübertragung kontrollieren, einschalten, beenden und verändern. Er kann dabei insbesondere auf einzelne Halbleiterschaltungen HS oder auch weitere Schaltelemente und elektrische Komponenten zugreifen.

Die Erweiterung 13 des Trägers 12 ist eine zusätzliche Freifläche, die bereits auf dem Wafer 10 als solche besteht. Die Oberfläche der Erweiterung 13 kann durch mikromechanische Bearbeitung bzw. Strukturierung, wie beispielsweise Ätzen, so behandelt und verändert werden, daß sie zur Aufnahme der weiteren Schaltelemente und Komponenten geeignet ist, die für die Datenübertragung eingesetzt werden sollen. So kann in der Erweiterung 13 beispielsweise ein in den Fig. 7 und 8 dargestellter V-Graben 19 zur Aufnahme eines positionsgenau an die Fotodiode 14 angekoppelten Lichtwellenleiters 20 angebracht sein. Der V-Graben 19 ist beispielsweise 150 µm tief. Es kann selbstverständlich auch mehr als ein V-Graben 19 auf der Erweiterung 13 erzeugt werden. Durch geeignete Strukturierung kann auch eine Unterlage für weitere Schaltelemente und Komponenten auf der Erweiterung 13 geschaffen werden. "Strukturierung" kann dabei Entfernung von Material bedeuten, beispielsweise beim V-Graben 19, aber auch Aufbau von Materialien. Schaltelemente und Komponenten sind beispielsweise Temperatursensoren, Kühlelemente, Gitter, Dämpfungselemente und Justierelemente sowie Relais, Linsen, Spiegelelemente, optische Filter, optische Isolatoren und optische Verstärker.

Auf der Erweiterung 13 des Trägers 12 kann gemäß Fig. 6 auch ein Lichtleiter 21 angebracht sein, der aus Glas oder aus einem Polymer oder aus dem Halbleitermaterial der Erweiterung 13 selbst bestehen kann. Er kann zur optischen Verbindung von auf dem Träger 12 befindlichen Komponenten dienen, beispielsweise einer Laserdiode 22 mit einem Modulator oder einem optischen Isolator 23. Der Lichtleiter 21 kann beispielsweise aus Siliziumdioxid erzeugt werden, beispielsweise in Form eines durch PECVD (Plasma Enhanced Chemical Vapor Deposition) abgeschiedenen LTOs (Low Temperature Oxide).

Der Mikrocontroller 17 kann - wie bereits erwähnt - beispielsweise zur Überwachung der einwandfreien Arbeitsweise einer kompletten, auf einem Träger 12 mit Erweiterung 13 angebrachten Schaltung und gegebenenfalls zur Korrektur von Parametern dienen. Das gilt beispielsweise auch für die Temperaturstabilisierung der kompletten Schaltung über Temperatursensoren und Kühlelemente. Das gilt auch für die Einhaltung oder Veränderung der Wellenlänge bei der Datenübertragung durch Beeinflussung eines Gitters oder Spiegels. Ebenso können Relais und Linsen sowie Dämpfungs- und Justierelemente durch den Mikrocontroller 17 überwacht und beeinflußt werden. Der Mikrocontroller 17 kann auch zur Verstellung von Spiegelelementen verwendet werden, die beispielsweise Schalterfunktion haben oder mittels derer der Strahlengang von für die Datenübertragung verwendetem Licht verändert werden kann. Es ist dann beispielsweise möglich, an eine Fotodiode 14 oder an eine Laserdiode unterschiedliche, auf der Erweiterung 13 vorhandene Lichtwellenleiter 20 anzuschalten.

Im Vorangehenden ist die Anordnung nach der Erfindung im wesentlichen für eine Empfangsschaltung beschrieben. Die Erfindung ist im gleichen Sinne auch für andere Schaltungen anwendbar, beispielsweise für eine Sendeschaltung, bei welcher statt der Fotodiode 14 eine Laserdiode mit einer Treiberschaltung und eventueller Monitordiode eingesetzt wird.

## Patentansprüche

1. Anordnung mit einem Träger (12) aus Halbleitermaterial und mindestens zwei unterschiedlichen elektronischen Halbleiterschaltungen (HS), bei welcher jeder der Halbleiterschaltungen (HS) ein Bauteil aus Halbleitermaterial ist, das eine aktive Fläche und elektrische Kontakte aufweist, und bei welcher korrespondierende Kontakte der Halbleiterschaltungen (HS) elektrisch leitend miteinander verbunden sind, wobei der Träger (12) eine aus dem gleichen Material bestehende, eine Einheit mit demselben bildende Erweiterung (13) zur Aufnahme weiterer Schaltelemente bzw. Komponenten aufweist wobei durch Metallisierung des Trägers (12) auf seiner Oberfläche mit den Halbleiterschaltungen (HS) verbundene, elektrisch leitende Kontakte (18) angebracht sind, **dadurch gekennzeichnet,**
**daß** die Halbleiterschaltungen (HS) gemeinsam in dem Träger (12) erzeugt und elektrisch leitend mit einander verbunden sind.

2. Anordnung nach Anspruch 1, **dadurch gekennzeichnet, daß** die Erweiterung (13) zur Aufnahme der Schaltelemente bzw. Komponenten durch mikromechanische Behandlung strukturiert ist.

3. Anordnung nach Anspruch 1, **dadurch gekennzeichnet, daß** eine der Halbleiterschaltungen (HS) eine Fotodiode (14) ist,

4. Anordnung nach Anspruch 1, **dadurch gekennzeichnet, daß** eine Fotodiode als separates Bauteil auf dem Träger (12) angebracht ist.

5. Anordnung nach Anspruch 1, **dadurch gekennzeichnet, daß** eine der Halbleiterschaltungen (HS) eine Laserdiode ist.

6. Anordnung nach Anspruch 1, **dadurch gekennzeichnet, daß** eine Laserdiode als separates Bauteil auf dem Träger (12) angebracht ist.

7. Anordnung nach Anspruch 1, **dadurch gekennzeichnet, daß** eine der Halbleiterschaltungen (HS) ein intelligentes elektronisches Bauteil mit Speicherfunktion ist.

8. Anordnung nach Anspruch 7, **dadurch gekennzeichnet, daß** das elektronische Bauteil ein Mikrocontroller (17) ist.

9. Anordnung nach einem der Ansprüche 1 bis 8, **dadurch gekennzeichnet, daß** der Träger (12) weitere Halbleiterschaltungen (HS) aufweist, beispielsweise optische Filter, optische Isolatoren, optische Verstärker und Monitordioden.

10. Anordnung nach Anspruch 1, **dadurch gekennzeichnet, daß** die Erweiterung (13) des Trägers (12) mindestens einen V-Graben (19) zur Aufnahme eines Lichtwellenleiters (20) hat.

11. Anordnung nach Anspruch 1 oder 10, **dadurch gekennzeichnet, daß** auf der Erweiterung (13) des Trägers (12) Relais, Linsen, optische Filter und/oder Spiegelelemente angebracht sind.

12. Anordnung nach einem der Ansprüche 1, 10 oder 11, **dadurch gekennzeichnet, daß** auf der Erweiterung (13) des Trägers (12) ein als Verbinder dienender Lichtleiter (21) angebracht ist.

13. Anordnung nach Anspruch 12, **dadurch gekennzeichnet, daß** der Lichtleiter (21) aus Glas besteht.

14. Anordnung nach Anspruch 13, **dadurch gekennzeichnet, daß** der Lichtleiter (21) aus Siliziumdioxid besteht.

15. Anordnung nach Anspruch 12, **dadurch gekennzeichnet, daß** der Lichtleiter (21) aus einem Polymer besteht.

16. Anordnung nach Anspruch 12, **dadurch gekennzeichnet, daß** der Lichtleiter (21) aus Halbleitermaterial besteht.

17. Anordnung nach einem der Ansprüche 1 bis 16, **dadurch gekennzeichnet, daß** der Träger aus Halbleitermaterial aus Silizium, Gallium-Arsenid oder Indium-Phosphid besteht.

18. Verwendung einer Anordnung nach einem der Ansprüche 1 bis 17 zur schnellen Datenübertragung mit Frequenzen, die über 1 GHz liegen.

## Claims

1. An arrangement with a support (12) made of semiconductor material and at least two different electronic semiconductor circuits (HS), where each of the semiconductor circuits is a component made of semiconductor material which comprises an active surface and electrical contacts, and where corresponding contacts of the semiconductor circuits (HS) are interconnected in an electrically conductive manner wherein the support (12) comprises an expansion (13) for receiving other circuit elements or components wherein the expansion is made of the same material as the support (12) and forms a unit with it, wherein metallization of the support (12) provides contacts (18) on its surface which are connected to the semiconductor circuits (HS) and are interconnected in an electrically conductive manner, **characterized in that** the semiconductor circuits (HS) are made of semiconductor material; they are located on a common support (12) and are interconnected in an electrically conductive manner.

2. Arrangement as claimed in claim 1, **characterized in that** the expansion (13) for receiving the circuit elements or components is structured by micromechanical processing.

3. Arrangement as claimed in claim 1, **characterized in that** one of the semiconductor circuits (HS) is a photodiode (14).

4. Arrangement as claimed in claim 1, **characterized in that** a photodiode is installed as a separate component on the support (12).

5. Arrangement as claimed in claim 1, **characterized in that** one of the semiconductor circuits (HS) is a laser diode.

6. Arrangement as claimed in claim 1, **characterized in that** a laser diode is installed as a separate component on the support (12).

7. Arrangement as claimed in claim 1, **characterized in that** one of the semiconductor circuits (HS) in an intelligent electronic component with a memory function.

8. Arrangement as claimed in claim 7, **characterized in that** the electronic component is a microcontroller (17).

9. Arrangement as claimed in one of the claim 1 to 8, **characterized in that** the support (12) comprises other semiconductor circuits (HS), for example optical filters, optical insulators, optical amplifiers and monitor diodes.

10. Arrangement as claimed in claim 1, **characterized in that** the expansion (13) of support (12) contains at least one V-groove (19) for receiving an optical fiber (20).

11. Arrangement as claimed in claim 1 or 10, **characterized in that** relays, lenses, optical filters and / or mirror elements are installed on the expansion (13) of support (12).

12. Arrangement as claimed in one of the claims 1, 10 or 11, **characterized in that** an optical guide (21) which is used as a connector is installed on the expansion (13) of support (12).

13. Arrangement as claimed in claim 12, **characterized in that** the optical guide (21) is made of glass.

14. Arrangement as claimed in claim 13, **characterized in that** the optical guide (21) is made of silicon dioxide.

15. Arrangement as claimed in claim 12, **characterized in that** the optical guide (21) is made of a polymer.

16. Arrangement as claimed in claim 12, **characterized in that** the optical guide (21) is made of semiconductor material.

17. Arrangement as claimed in one of the claims 1 to 16, **characterized in that** the support is made of a silicon, gallium-arsenide or indium-phosphide semiconductor material.

18. Utilization of an arrangement as claimed in one of claims 1 to 17 for fast data transmission at frequencies above 1 GHz.

## Revendications

1. Arrangement avec un support (12) en matériau semi-conducteur et au moins deux circuits semi-conducteurs (HS) électroniques différents, dans lequel chacun des circuits semi-conducteurs (HS) est un composant en matériau semi-conducteur qui présente une surface active et des contacts électriques, et dans lequel des contacts correspondants des circuits semi-conducteurs (HS) sont reliés l'un avec l'autre de manière à conduire le courant, étant donné que le support (12) présente une extension (13) constituée du même matériau et formant une unité avec ce dernier pour le logement d'autres éléments de commutation ou de composantes, étant donné que sont installés des contacts conducteurs de courant (18) reliés avec les circuits semi-conducteurs (HS) par métallisation du support (12) à sa surface, **caractérisé en ce que**
les circuits semi-conducteurs (HS) sont générés ensemble dans le support (12) et sont reliés l'un avec l'autre de manière à conduire le courant.

2. Arrangement selon la revendication 1, **caractérisé en ce que** l'extension (13) destinée au logement des éléments de commutation ou composante est structurée par traitement micromécanique.

3. Arrangement selon la revendication 1, **caractérisé en ce que** l'un des circuits semi-conducteurs (HS) est une photodiode (14).

4. Arrangement selon la revendication 1, **caractérisé en ce qu'**une photodiode est installée comme composant séparé sur le support (12).

5. Arrangement selon la revendication 1, **caractérisé en ce que** l'un des circuits semi-conducteurs (HS) est une diode laser.

6. Arrangement selon la revendication 1, **caractérisé en ce qu'**une diode laser est installée comme composant séparé sur le support (12).

7. Arrangement selon la revendication 1, **caractérisé en ce que** l'un des circuits semi-conducteurs (HS) est un composant électronique intelligent à fonction de mémoire.

8. Arrangement selon la revendication 7, **caractérisé en ce que** le composant électronique est un microcontrôleur (17).

9. Arrangement selon l'une quelconque des revendications 1 à 8, **caractérisé en ce que** le support (12) présente d'autres circuits semi-conducteurs (HS), par exemple des filtres optiques, des isolateurs optiques, des amplificateurs optiques et de diodes moniteur.

10. Arrangement selon la revendication 1, **caractérisé en ce que** l'extension (13) du support (12) présente au moins une fosse en V (19) pour le logement d'une fibre optique (20).

11. Arrangement selon la revendication 1 ou 10, **caractérisé en ce que** des relais, lentilles, filtres optiques et/ou éléments réflecteurs sont installés sur l'extension (13) du support (12).

12. Arrangement selon l'une quelconque des revendications 1, 10 ou 11, **caractérisé en ce qu'**une fibre optique (21) qui sert de connecteur est installée sur l'extension (13) du support (12).

13. Arrangement selon la revendication 12, **caractérisé en ce que** la fibre optique (21) est en verre.

14. Arrangement selon la revendication 13, **caractérisé en ce que** la fibre optique (21) est en dioxyde de silicium.

15. Arrangement selon la revendication 12, **caractérisé en ce que** la fibre optique (21) est en un polymère.

16. Arrangement selon la revendication 12, **caractérisé en ce que** la fibre optique (21) est en matériau semi-conducteur.

17. Arrangement selon l'une quelconque des revendications 1 à 16, **caractérisé en ce que** le support est en matériau semi-conducteur en silicium, arséniure de gallium ou en phosphure d'indium.

18. Utilisation d'un arrangement selon l'une quelconque des revendications 1 à 17 pour la transmission de données rapide avec des fréquences supérieures à 1 GHz.
